# EUROPEAN PATENT APPLICATION

(11) **EP 2 362 427 A2**
(43) Date of publication of application: **31.08.2011**
(21) Application number: 11155836.7
(22) Date of filing: 24.02.2011
(51) Int. Cl.: H01L 31/0224, H01L 31/032, H01L 31/0368, H01L 31/0376, H01L 31/0392, H01L 31/05, H01L 27/142

(54) **Thin-film solar cell**

(30) Priority: 25.02.2010 JP 2010040626; 21.09.2010 JP 2010210418
(71) Applicant: Fuji Electric Systems Co., Ltd., Tokyo 141-0032 (JP)
(72) Inventor: Shimosawa, Makoto, Tokyo 141-0032 (JP); Masuda, Nobuyuki, Tokyo 141-0032 (JP)
(74) Representative: Appelt, Christian W.

(57) **Abstract**

Disclosed is a thin-film solar cell that has a structure in which a plurality of unit solar cells is connected in series and is capable of preventing the formation position of collector holes from being limited and reducing power loss, as compared to the related art.

A thin-film solar cell 10 includes a plurality of unit solar cells (UCs) formed by linearly removing and dividing each layer (a first electrode layer 12, a photoelectric conversion layer 13, a second electrode layer 14, a third electrode layer 16, and a fourth electrode layer 17) formed on the front surface and the rear surface of an insulating substrate 11. The unit solar cells are connected in series to each other through a plurality of collector holes 19 and connection holes 20. At least one of a first linearly removed portion 21 formed in each layer on the front surface of the insulating substrate 11 and a second linearly removed portion 22 formed in each layer on the rear surface of the insulating substrate includes a bent portion, and the plurality of collector holes 19 is arranged so as to be dispersed in the entire second electrode layer 14 of each unit solar cell (UC).

## Description

### BACKGROUND OF THE INVENTION

### 1. Field of the Invention

The present invention relates to a solar cell that uses sunlight to generate power, and more particularly, to a thin-film solar cell having a structure in which a plurality of unit solar cells (unit cells) is connected in series to each other.

### 2. Description of the Related Art

In recent years, solar cells have drawn attention as one of means for solving global environmental problems. Among the solar cells, in a solar cell including a photoelectric conversion layer made of amorphous silicon, microcrystalline silicon, a compound, such as CdTe (cadmium telluride) or CIGC (copper-indium-gallium-selenide), or an organic material, it is possible to form a thin photoelectric conversion layer with a thickness of about several hundreds of nanometers (nm) to several micrometers (µm). Therefore, it is possible to significantly reduce the amount of material used, as compared to the solar cell according to the related art. In particular, the solar cell has drawn attention in terms of a low manufacturing cost. The solar cell is called a thin-film solar cell. In addition, one of the advantages of the thin-film solar cell is that the thin-film solar cell can be formed on various kinds of substrates, unlike the crystalline silicon solar cell according to the related art.

Since the voltage generated by a single solar cell is low, a structure is generally used in which a plurality of unit solar cells (unit cells) is connected in series to each other to increase the generated voltage. In the case of the thin-film solar cell, in general, an electrode layer and a photoelectric conversion layer are formed on one substrate and each of the formed layers is divided into a plurality of unit cells by, for example, laser patterning, thereby achieving a structure in which the unit cells are connected in series to each other. For example, JP-A-10-233517 discloses a thin-film solar cell in which a plurality of unit cells is formed on a sheet (film) substrate and the unit cells are connected in series to each other by collect holes and connection holes passing through the sheet (film) substrate. The solar cell structure is called an SCAF (Series-Connection through Apertures formed on Film) structure.

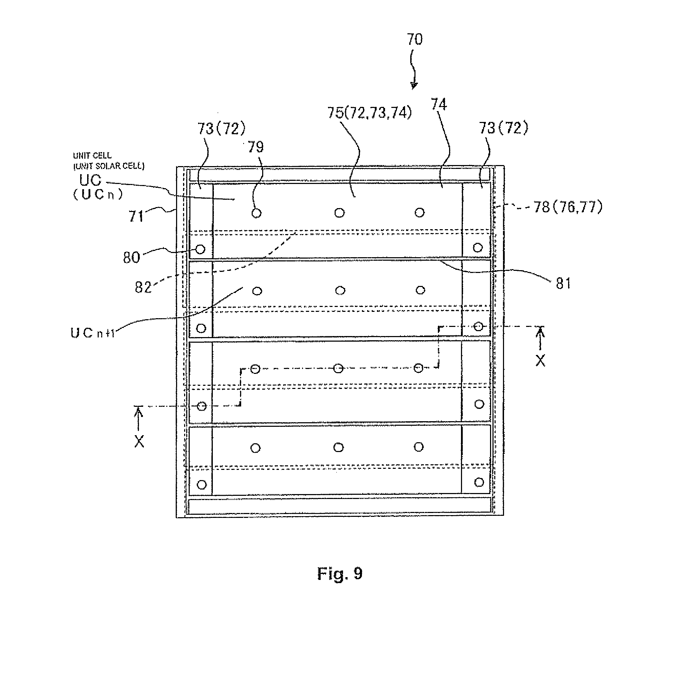

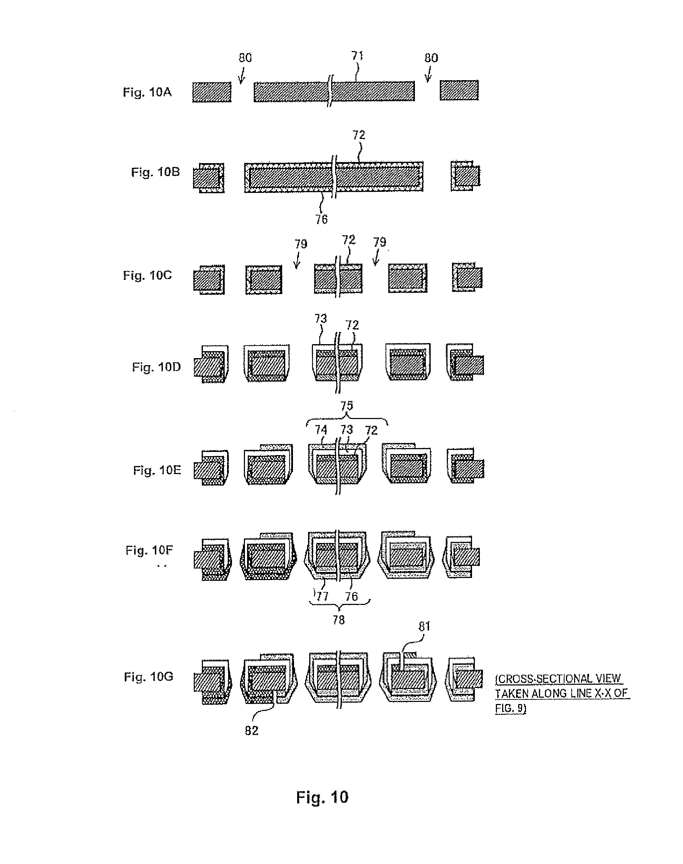

Fig. 9 is a plan view illustrating a thin-film solar cell having the SCAF structure according to the related art, and Figs. 10A to 10G are cross-sectional views (corresponding to cross-sectional views taken along the line X-X of Fig. 9) illustrating a process sequence of a method of manufacturing the thin-film solar cell having the SCAF structure according to the related art. In Figs. 10A to 10G, the electrode layers at the same potential when the thin-film solar cell receives light and generates power are hatched.

As shown in Fig. 9 and Figs. 10A to 10G, a thin-film solar cell 70 includes an insulating substrate 71. A photoelectric conversion portion 75 including a first electrode layer 72, a photoelectric conversion layer 73, and a second electrode layer 74 formed therein in this order is formed on the front surface of the insulating substrate 71, and a rear electrode layer 78 including a third electrode layer 76 and a fourth electrode layer 77 formed therein in this order is formed on the rear surface of the insulating substrate 71. In the thin-film solar cell 70 shown in Fig. 9 and Figs. 10A to 10G, the first electrode layer 72 and the photoelectric conversion layer 73 are formed in the same range of the front surface of the insulating substrate 71, and the third electrode layer 76 and the fourth electrode layer 77 are formed in the same range of the rear surface of the insulating substrate 71.

In addition, portions each having a two-layer structure of the first electrode layer 72 and the photoelectric conversion layer 73 are formed at both ends of the front surface of the insulating substrate 71 in the horizontal direction of Fig. 9. In the entire central portion other than the two two-layer portions, the second electrode layer 74 is formed on the photoelectric conversion layer 73, and the photoelectric conversion portion 75 having a three-layer structure of the first electrode layer 72, the photoelectric conversion layer 73, and the second electrode layer 74 is formed.

Each layer on the front surface and the rear surface of the insulating substrate 71 is linearly removed and divided into a plurality of unit cells (UCs), each having a unit portion (hereinafter, referred to as a "unit photoelectric conversion portion") of the photoelectric conversion portion 75 and a unit portion (hereinafter, referred to as a "unit rear electrode portion") of the rear electrode layer 78, on the insulating substrate 71.

In each of the unit cells (UCs), the second electrode layer 74 and the rear electrode layer 78 (the third electrode layer 76 and the fourth electrode layer 77) are electrically connected to each other through collector holes 79. In the front surface of the insulating substrate 71, a first linearly removed portion 81 for forming the unit photoelectric conversion portion is spaced a predetermined distance from a second linearly removed portion 82 for forming the unit rear electrode portion on the rear surface of the insulating substrate 71, with the insulating substrate 71 interposed therebetween. Therefore, of two adjacent unit cells (UCs), in a portion of one unit cell (UCₙ) in which connection holes 80 are provided, the rear electrode layer 78 opposite to the second electrode layer 74 with the insulating substrate 71 interposed therebetween is electrically connected to the second electrode layer 74 of the other unit cell (UCₙ₊₁) through the collector holes 79. In this way, the unit cell (UCₙ) can be electrically connected in series to an adjacent unit cell (UCₙ₊₁) through the connection holes 80 and the rear electrode layer 78.

Next, the process sequence of the method of manufacturing the thin-film solar cell according to the related art will be described with reference to Figs. 10A to 10G. First, as shown in Fig. 10A, a plurality of connection holes 80 is formed in the insulating substrate 71 at predetermined positions. For example, a polyimide-based film, a polyethylene naphthalate (PEN)-based film, a polyether sulfone (PES)-based film, a polyethylene terephthalate (PET)-based film, or an aramid-based film may be used as the insulating substrate 71. The connection hole 80 is formed in a circular shape and has a diameter of 1 mm order. The connection hole 80 may be formed by a mechanical means such as a punch.

Then, as shown in Fig. 10B, the first electrode layer 72 is formed on the front surface of the insulating substrate 71, and the third electrode layer 76 is formed on the rear surface of the insulating substrate 71. In this case, the first electrode layer 72 and the third electrode layer 76 overlap each other so as to be electrically connected on the inner circumferential surface of the connection hole 80.

Then, as shown in Fig. 10C, a plurality of collector holes 79 is formed in the insulating substrate 71. Similar to the connection hole 80, the collector hole 79 is formed in a circular shape and has a diameter of 1 mm order. The collector hole 79 may be formed by a mechanical means such as a punch.

Then, as shown in Fig. 10D, the photoelectric conversion layer 73 is formed on the first electrode layer 72. The photoelectric conversion layer 73 is a thin semiconductor layer. For example, an amorphous silicon (a-Si) film may be used as the photoelectric conversion layer 73.

Then, as shown in Fig. 10E, the second electrode layer 74 is formed on the photoelectric conversion layer 73. The second electrode layer 74 is a transparent electrode layer. For example, an indium tin oxide (ITO) film may be used as the second electrode layer 74. When the second electrode layer 74 is formed, the connection hole 80 and a peripheral region thereof are covered with a mask such that the second electrode layer 74 is not formed in a portion in which the connection hole 80 is formed.

Then, as shown in Fig. 10F, the fourth electrode layer 77 is formed on the third electrode layer 76 that is formed on the rear surface of the insulating substrate 71. The fourth electrode layer 77 is a low-resistance conductive layer. For example, a low-resistance metal film may be used as the fourth electrode layer 77. In this case, the second electrode layer 74 and the fourth electrode layer 77 overlap each other so as to be electrically connected on the inner circumferential surface of the collector hole 79.

The photoelectric conversion portion 75 including the first electrode layer 72, the photoelectric conversion layer 73, and the second electrode layer 74 formed on the front surface of the insulating substrate 71 and the rear electrode layer 78 including the third electrode layer 76 and the fourth electrode layer 77 formed on the rear surface of the insulating substrate 71 are formed by the above-mentioned process.

Then, as shown in Fig. 10G, each layer formed on the front surface of the insulating substrate 71 is linearly removed to form the first linearly removed portion 81, and each layer formed on the rear surface of the insulating substrate 71 is linearly removed to form the second linearly removed portion 82. In this way, the photoelectric conversion portion 75 formed on the front surface of the insulating substrate 71 and the rear electrode layer 78 formed on the rear surface of the insulating substrate 71 are divided into a plurality of unit portions, and a plurality of unit cells (UC), each having a unit portion (unit photoelectric conversion portion) of the photoelectric conversion portion 75 and a unit portion (unit rear electrode layer) of the rear electrode layer, is formed on the insulating substrate 71. As described above, in each of the unit cells (UC), the second electrode layer 74 and the fourth electrode layer 77 (that is, the rear electrode layer 78) can be electrically connected to each other through the collector holes 79, and the first electrode layer 72 of one unit cell (UCₙ) of two adjacent unit cells (UCs) can be electrically connected to the third electrode layer 76 (that is, the rear electrode layer 78) of the other unit cell (UCₙ₊₁) through the connection hole 80.

When light is emitted to the thin-film solar cell 70 and carriers (electrons and holes) are generated in the photoelectric conversion layer 73 of each unit cell (UC), one kind of carrier flows to the second electrode layer (transparent electrode layer) 74 by the electric field in the p-n junction. Since the second electrode layer 74 is electrically connected to the fourth electrode layer 77 (the rear electrode layer 78) on the inner circumferential surface of the collector hole 79, the carrier flowing to the second electrode layer 74 is moved to the rear surface of the insulating substrate 71 through the collector hole 79. Since the photoelectric conversion layer 73 can be substantially regarded as an insulating layer, the first electrode layer 72 and the second electrode layer 74 are substantially insulated from each other. The carrier moved to the rear surface of the insulating substrate 71 is moved to the connection hole 80. The second electrode layer 74 is not formed in a portion in which the connection hole 80 is formed, and the first electrode layer 72 and the third electrode layer 76 (the rear electrode layer 78) are electrically connected to each other on the inner circumferential surface of the connection hole 80. Therefore, the carrier is moved to the front surface of the insulating substrate 71 through the connection hole 80 again. Then, the carrier is moved to the photoelectric conversion layer 73 of an adjacent unit cell (UC) on the front surface of the insulating substrate 71. As such, in the thin-film solar cell 70 having the SCAF structure according to the related art, a plurality of unit cells (UCs) is connected in series to each other through the collector holes 79 and the connection holes 80.

In the thin-film solar cell according to the related art, in each unit cell, the second electrode layer, which is a transparent electrode layer, and the rear electrode layer are electrically connected to each other through the collector holes, and the power loss (power collection loss) of the transparent electrode layer with high resistance is reduced a little.

However, in the thin-film solar cell according to the related art, as shown in Fig. 9, the unit photoelectric conversion portion and the unit rear electrode layer forming each unit cell (UC) deviate from each other in the direction (the vertical direction of Fig. 9) in which the unit cells are arranged, and the positions where the collector holes and the connection holes in each unit cell (UC) are formed are limited. Therefore, the positions where the collector holes and the connection holes are formed are not optimized in terms of power collection efficiency. Therefore, the thin-film solar cell needs to be improved.

### SUMMARY OF THE INVENTION

The invention has been made in order to solve the above-mentioned problems and an object of the invention is to provide a thin-film solar cell capable of preventing the positions where collector holes and connection holes are formed from being limited and reducing power loss, as compared to the related art.

According to an aspect of the invention, a thin-film solar cell includes: a plurality of unit solar cells that is formed on an insulating substrate. Each of the plurality of unit solar cells includes: a photoelectric conversion portion that includes a first electrode layer, a photoelectric conversion layer, and a second transparent electrode layer sequentially formed on a front surface of the insulating substrate; and a rear electrode layer that is formed on a rear surface of the insulating substrate. Each of the unit solar cells includes a second region in which a portion of a first region in which the second electrode layer or the photoelectric conversion layer and the second electrode layer are not formed in a first electrode layer formation region of one of two adjacent unit solar cells overlaps a portion of the rear electrode layer of the other unit solar cell with the insulating substrate interposed therebetween. The second region includes at least one connection hole passing through the insulating substrate. The first electrode layer of one of two adjacent unit solar cells and the rear electrode layer of the other unit solar cell are electrically connected to each other through the connection holes, thereby connecting the plurality of unit solar cells in series. Each of the unit solar cells includes a third region in which the photoelectric conversion portion and the rear electrode layer that face each other with the insulating substrate interposed therebetween form a portion of the unit solar cell in a structure in which the second electrode layer and the rear electrode layer are electrically connected to each other through a plurality of collector holes passing through the insulating substrate. At least one of the first electrode layer and the rear electrode layer includes a bent portion and forms the second region.

The bent portion may be disposed in the first region in which the second electrode layer is not formed in the vicinity of a portion in which the connection holes are formed.
Alternatively, each unit solar cell may include: a first overlap region (overlap region C) in which a portion of a first electrode layer formation region of one of two adjacent unit solar cells faces a portion of the rear electrode layer of the other unit solar cell with the insulating substrate interposed therebetween; and a fourth region (overlap region D) in which a laminated portion obtained by sequentially laminating the first electrode layer, the photoelectric conversion layer, and the second transparent electrode layer faces the rear electrode layer, with the insulating substrate interposed therebetween, to form the unit solar cell. A portion of the fourth region may be arranged so as to include a second electrode layer separation region in which at least the second electrode layer is electrically separated and the first electrode layer is not electrically separated and a fifth region (overlap region E) in which a portion of the first electrode layer of one unit solar cell overlapped with the second electrode layer separation region faces a portion of the rear electrode layer of another unit solar cell in the first overlap region, with the insulating substrate interposed therebetween. The collector holes may be arranged in a portion of the fourth region except for the first overlap region and the second electrode layer separation region. At least one connection hole passing through the insulating substrate may be formed in the fifth region. The first electrode layer of one of two adjacent unit solar cells and the rear electrode layer of the other unit solar cell may be electrically connected to each other through the connection holes, thereby connecting the plurality of unit solar cells in series.

The bent portion may be disposed in the second electrode layer separation region.
The plurality of collector holes may be arranged so as to be dispersed in the third region of each unit solar cell or the entire fourth region of each unit solar cell except for the first overlap region and the second electrode layer separation region. In this case, preferably, the plurality of collector holes is arranged in a lattice such that they are substantially uniformly dispersed in the second electrode layer of each of the unit solar cells.

In the unit solar cell according to the above-mentioned aspect, each layer formed on the front surface and the rear surface of the insulating substrate may be linearly removed and divided into a plurality of portions each having a unit photoelectric conversion portion and a unit rear electrode portion. A linear means is not necessarily used to divide each layer into a plurality of portions, but a mask may be used to divide each layer into a plurality of portions during manufacture.

The bent portion may be formed in at least one of the first electrode layer and the rear electrode layer.

According to the thin-film solar cell of the above-mentioned aspect of the invention, at least one of the first electrode layer formed on the front surface of the insulating substrate and the rear electrode layer formed on the rear surface of the insulating substrate includes the bent portion in each unit solar cell. Therefore, the positions where the unit photoelectric conversion portion and the unit rear electrode layer forming the unit solar cell are optimized. As a result, it is possible to form the collector holes or the connection holes at desired positions in each unit solar cell.

The region in which the second electrode layer is not formed is provided in the vicinity of a portion in which the connection holes are formed, and the bent portion is disposed in the region in which the second electrode layer is not formed. Alternatively, the second electrode layer is electrically separated into the first region in which the connection holes are provided and the second region in which the connection hole is not provided, and the bent portion is arranged in the first region. According to this structure, during the processing of the bent portion, for example, even when the photoelectric conversion layer is damaged, a leakage path is not formed due to the electrical connection between the first electrode layer and the second electrode layer. Therefore, it is possible to prevent a reduction in the output of the thin-film solar cell due to the process of removing each layer.

A plurality of collector holes is arranged so as to be dispersed in the entire second electrode layer of each unit solar cell. According to this structure, it is possible to shorten the path of a current flowing through the second electrode layer with high resistance and improve the uniformity of current flow. Therefore, it is possible to significantly reduce power loss.
The "numbering" of the regions as used in this application, namely "first region" to "fifth region" has to be understood only as a means to distinguish each of the regions from each other, i.e. to define different regions. A reference e.g. to a "fourth region" either in the claims or in the specification therefore does not necessarily require that the respective device also comprises a first, a second and a third region, if not explicitly mentioned or indicated.
The term "solar cells" as mentioned in this application especially refers to a "photovoltaic device", and such "solar cells" can comprise multiple "unit solar cells", which are typically electrically connected in series.

### BRIEF DESCRIPTION OF THE DRAWINGS

Fig. 1 is a plan view illustrating a thin-film solar cell according to a first embodiment of the invention;
Fig. 2 is a plan view illustrating a thin-film solar cell according to a second embodiment of the invention;
Figs. 3A to 3D are exploded perspective views illustrating the thin-film solar cell according to the second embodiment of the invention;
Fig. 4 is a cross-sectional view taken along the line A-A of Fig. 2;
Fig. 5 is a plan view illustrating a thin-film solar cell according to a third embodiment of the invention;
Fig. 6 is a plan view illustrating a thin-film solar cell according to a fourth embodiment of the invention;
Fig. 7 is a cross-sectional view taken along the line B-B of Fig. 6;
Fig. 8 is a plan view illustrating a thin-film solar cell according to a fifth embodiment of the invention;
Fig. 9 is a plan view illustrating a thin-film solar cell according to the related art; and
Figs. 10A to 10G are diagrams illustrating a process sequence of a method of manufacturing the thin-film solar cell according to the related art and correspond to the cross-sectional view of Fig. 9 taken along the line X-X.

### DESCRIPTION OF THE PREFERRED EMBODIMENTS

Hereinafter, exemplary embodiments of the invention will be described with reference to the accompanying drawings.

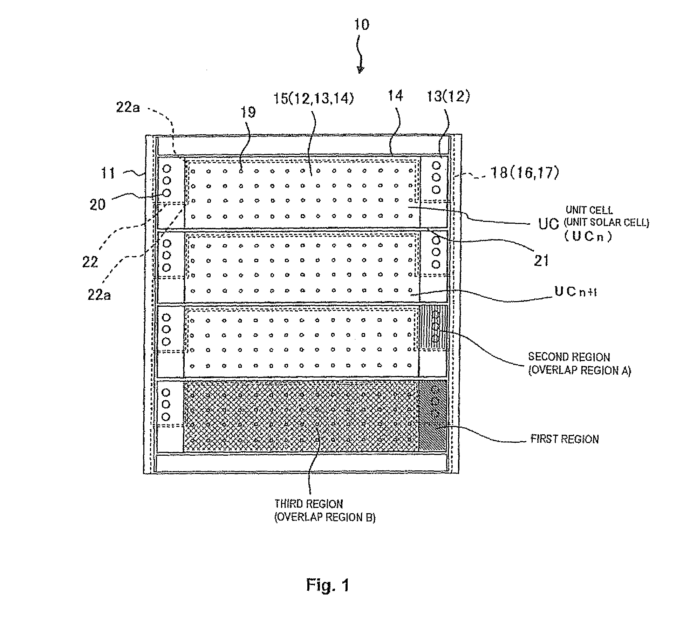

Fig. 1 is a plan view illustrating a thin-film solar cell 10 according to a first embodiment of the invention. The thin-film solar cell 10 has an SCAF structure, and the basic structure of the thin-film solar cell 10 is the same as that of the thin-film solar cell 70 according to the related art shown in Figs. 9 and 10. That is, the thin-film solar cell 10 includes a flexible insulating substrate 11. A photoelectric conversion portion 15 having a first electrode layer 12, a photoelectric conversion layer 13, and a second electrode layer 14 sequentially formed therein is provided on the front surface of the insulating substrate 11, and a rear electrode layer 18 having a third electrode layer 16 and a fourth electrode layer 17 sequentially formed therein is provided on the rear surface of the insulating substrate 11.

Each of the layers provided on the front and rear surfaces of the insulating substrate 11 is linearly removed and divided into a plurality of portions by, for example, a laser patterning process. In this way, a plurality of unit solar cells (unit cells: UCs), each having a unit photoelectric conversion portion and a unit rear electrode portion, is formed in the insulating substrate 11. In each of the layers provided on the front surface of the insulating substrate 11, the linearly removed portion is a first linearly removed portion 21. In each of the layers provided on the rear surface of the insulating substrate 11, the linearly removed portion is a second linearly removed portion 22.

As such, in this embodiment, each of the layers provided on the front and rear surfaces of the insulating substrate is linearly removed and divided into the unit solar cells each having the unit photoelectric conversion portion and the unit rear electrode portion. However, a means for dividing each layer into a plurality of portions is not limited thereto. When a film is formed, a mask may be used to provide the divided portions. In addition, the shape of the separation portion does not need to be a line, but the separation portion may have any shape as long as it can electrically separate the layer.

In each unit cell (UC), the second electrode layer 14 and the fourth electrode layer 17 are electrically connected to each other through a plurality of collector holes 19. Of two adjacent unit cells (UCs), a series connection portion of the first electrode layer 12 in a part of one unit cell (UCₙ) in which connection holes 20 are provided is electrically connected to a bent portion of the third electrode layer 16 in the other unit cell (UCₙ₊₁) through the connection holes 20.

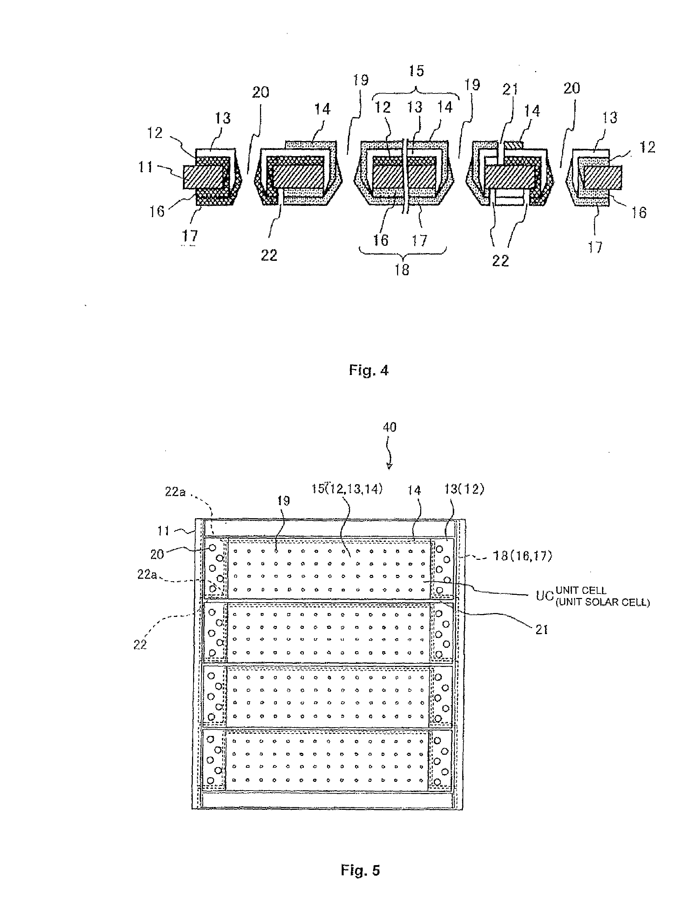

First regions in which only the first electrode layer 12 and the photoelectric conversion layer 13 are formed, but the second electrode layer 14 is not formed are provided on both side of the front surface of the insulating substrate 11 in the horizontal direction of Fig. 1. The first region does not form the photoelectric conversion portion 15. That is, the first region does not have a three-layer structure. Since the photoelectric conversion layer 73 serving as an insulating layer is formed at the position where the connection hole 80 is provided, the insulation of the second electrode layer 74 from the first electrode layer 72 and the rear electrode layer 78 electrically connected by the connection hole 80 is improved (see Figs. 10 and 4). However, when the insulation of the connection hole 80 from the second electrode layer 74 is ensured, the photoelectric conversion layer 73 is not necessarily formed around the connection hole 80, and the first region that does not form the photoelectric conversion portion 1 may be provided on the insulating substrate 11 such that only the first electrode layer 12 is formed, but the photoelectric conversion layer 13 and the second electrode layer 14 are not formed in the first region.

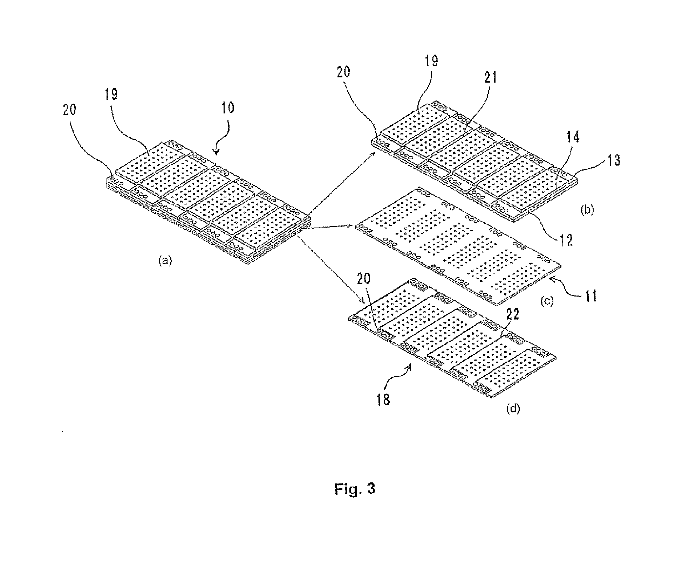

The second linearly removed portion 22 has a bent structure that is bent two times at an angle of 90° on both sides of the rear surface of the insulating substrate 11 in the horizontal direction of Fig. 1 (see Fig. 3D). An overlap region A (second region) is provided between a series connection portion of the first electrode layer 12, which is a portion of the first region of one unit cell (UCₙ₊₁) and a bent portion of the third electrode layer 16 of an adjacent unit cell (UCₙ) and the connection holes 20 are arranged in the overlap region A.

In this way, the series connection structure of adjacent unit cells (UCs) is formed.
Next, each component of the thin-film solar cell 10 will be described.
For example, a polyimide-based film, a polyethylene naphthalate (PEN)-based film, a polyether sulfone (PES)-based film, a polyethylene terephthalate (PET)-based film, or an aramid-based film may be used as a plastic substrate, which is the insulating substrate 11. When flexibility is not needed, for example, a glass substrate may be used.

The first electrode layer 12 and the third electrode layer 16 are silver (Ag) layers with a thickness of several hundreds of nanometers (nm) and are formed by a sputtering method. Although not shown in the drawings, a texture pattern may be formed on the surface of the first electrode layer 12 in order to disperse incident light to increase the amount of light absorbed by the photoelectric conversion layer 13. In this embodiment, a silver (Ag) electrode is used as the first electrode layer 12, but the invention is not limited thereto. For example, a laminated film obtained by forming titanium dioxide (TiO₂ with plasma resistance on the surface of a silver (Ag) electrode, a tin dioxide (SnO₂) film, or a zinc oxide (ZnO) film may be used as the first electrode layer 12. In addition, a material capable of forming the optimal texture pattern may be applied to form the first electrode layer 12.

The photoelectric conversion layer 13 is a thin semiconductor layer. In this embodiment, the photoelectric conversion layer 13 has a two-layer tandem structure of amorphous silicon (a-Si) and amorphous silicon germanium (a-SiGe). However, the invention is not limited thereto. For example, the photoelectric conversion layer 13 may be made of amorphous silicon carbide (a-SiC), amorphous silicon oxide (a-SiO), amorphous silicon nitride (a-SiN), microcrystalline silicon (µc-Si), microcrystalline silicon germanium (µc-SiGe), microcrystalline silicon carbide (µc-SiC), microcrystalline silicon oxide (µc-SiO), or microcrystalline silicon nitride (µc-SiN). In addition, the photoelectric conversion layer 13 may be made of a compound-based material or an organic material. Each layer of the photoelectric conversion layer 13 may be formed by, for example, a plasma chemical vapor deposition (plasma CVD) method, a sputtering method, a vapor deposition method, a catalytic chemical vapor deposition (Cat-CVD) method, or a photochemical vapor deposition (photo-CVD) method.

The second electrode layer 14 is a transparent electrode layer, and an indium tin oxide (ITO) film formed by the sputtering method is used as the second electrode layer 14. However, the invention is not limited thereto. For example, a tin dioxide (SnO₂) film or a zinc oxide (ZnO) film may be used as the second electrode layer 14.

The fourth electrode layer 17 is a low-resistance conductive film such as a metal film. In this embodiment, a nickel (Ni) film formed by the sputtering method is used as the fourth electrode layer 17. However, the invention is not limited thereto. The fourth electrode layer 17 may be made of materials other than nickel.

The collector holes 19 are dispersed in a third region (an overlap region B in which the photoelectric conversion portion 15 and the rear electrode layer 18 face each other with the insulating substrate 11 interposed therebetween), which is the entire second electrode layer 14 of each unit cell (UC). Six connection holes 20 are provided in each unit cell (UC) (three connection holes 20 are provided in a line on one side of the second electrode layer 14). The collector holes 19 and the connection holes 20 are formed by a mechanical means such as a punch. In this embodiment, the collector holes 19 and the connection holes 20 have a circular shape, and the diameter of each collector hole 19 is smaller than that of each connection hole 20. As such, the collector holes 19 with a diameter smaller than that of the connection holes 20 are arranged so as to be dispersed in the entire second electrode layer 14. Therefore, power loss in the second electrode layer 14 is reduced, and a reduction in the power generation area of the collector holes 19 is prevented. However, the invention is not limited thereto. The shapes, sizes, and number of collector holes 19 and connection holes 20 may appropriately vary depending on the specifications of the thin-film solar cell 10.

A method of manufacturing the thin-film solar cell 10 according to this embodiment is basically the same as the method of manufacturing the thin-film solar cell according to the related art shown in Figs. 10A to 10G and a description thereof will be omitted.
Next, some of the characteristics of the thin-film solar cell 10 according to this embodiment will be described in comparison with the thin-film solar cell (see Fig. 9) according to the related art.

First, one of the characteristics of the thin-film solar cell 10 is that the first linearly removed portion 21 in each layer provided on the front surface of the insulating substrate 11 has a linear shape, similar to the thin-film solar cell according to the related art, but the second linearly removed portion 22 in each layer provided on the rear surface of the insulating substrate 11 has a bent portion 22a. Specifically, in this embodiment, the second linearly removed portion 22 has a bent structure that is bent two times at an angle of 90° on both sides in the horizontal direction of Fig. 1, in order to substantially align the position of the unit photoelectric conversion portion with the position of the unit rear electrode layer in each unit cell (UC), with the insulating substrate 11 interposed therebetween. That is, in this embodiment, the second linearly removed portion 22 includes the bent portion 22a such that the unit photoelectric conversion portion and the unit rear electrode layer forming each unit cell (UC) are substantially aligned with each other with the insulating substrate 11 interposed therebetween.

In this way, in each unit cell (UC), the position where the collector holes 19 are formed is not limited (the position does not deviate), and it is possible to form a desired number of collector holes 19 at a desired position according to, for example, the manufacturing conditions of the thin-film solar cell. Therefore, it is possible to improve power collection efficiency.

The shape of the second linearly removed portion 22 is not limited to that in this embodiment. For example, the second linearly removed portion 22 may have an obliquely bent structure or may have a shape including a curve. In addition, the second linearly removed portion 22 may be formed in a straight line and the first linearly removed portion 21 may have a bent portion. Alternatively, each of the first linearly removed portion 21 and the second linearly removed portion 20 may have a bent portion.

Another characteristic of the thin-film solar cell 10 according to this embodiment is that a plurality of collector holes 19 is arranged so as to be dispersed in the entire second electrode layer 14 of each unit cell (UC). In this way, it is possible to significantly reduce the length of a current path in the second electrode layer 14 with high resistance and reduce power loss (power collection loss) in the second electrode layer 14.

In this embodiment, the plurality of collector holes 19 is arranged at substantially equal intervals in a lattice shape in the range of the second electrode layer 14 of each unit cell (UC). As such, when the collector holes 19 are substantially uniformly arranged in the entire second electrode layer 14, it is possible to significantly reduce the length of the current path in the second electrode layer 14 with high resistance and improve the uniformity of current flow. Therefore, it is possible to effectively reduce power collection loss.

However, when a linearly removed portion having a bent portion, such as the second linearly removed portion 22, is formed by, for example, laser patterning, two-dimensional sweeping in the X-Y direction by the laser is needed. That is, it is necessary to change the traveling direction of the laser beam during patterning. In this case, in order to ensure the processing accuracy of the bent portion, it is necessary to reduce the speed of the laser patterning. As a result, a laser acceleration and deceleration region is generated.

In the laser patterning, a laser pulse is applied at a constant frequency to remove a member in an irradiation portion. Therefore, when the laser pulse with intensity higher than a necessary level is applied to the same portion, the periphery of the irradiation portion is damaged. In the first embodiment, when the bent portion 22a of the second linearly removed portion 22 is processed, the laser acceleration and deceleration region is generated, and the number of laser pulses applied in the laser acceleration and deceleration region is more than that in the other regions. As a result, there is a concern that the photoelectric conversion layer 13 provided on the front surface of the substrate will be damaged and leakage will occur. When excessive energy is incident on the photoelectric conversion layer 13 provided on the front surface of the substrate, the photoelectric conversion layer 13 is crystallized or damaged and the first electrode layer 12 and the second electrode layer 14 are electrically connected to each other. Therefore, when the first linearly removed portion 21 has a bent portion, the leakage is more likely to occur.

In order to solve the above-mentioned problem, a method of shielding the laser beam using, for example, a shutter in the laser acceleration and deceleration region is considered. However, in this method, the cost of a laser processing apparatus increases, and the opening/closing speed of the shutter does not follow the oscillating frequency of the laser, which makes it difficult to ensure processing accuracy. In methods other than the laser processing, for example, in a process using an ultrasonic transducer or a sandblasting process, when the bent portion is formed, a processing acceleration and deceleration region is generated and excessive force or energy is applied to the photoelectric conversion layer 13. As a result, similar to the laser processing, there is a concern that the photoelectric conversion layer 13 will be damaged and leakage will occur.

In order to prevent the leakage and concern for the leakage, the thin-film solar cell 10 according to the first embodiment is improved as follows (second to fifth embodiments). The following embodiments can be applied to all thin-film solar cells in which the linearly removed portion has a bent portion, regardless of an object for bending the linearly removed portion formed in each layer on the substrate.

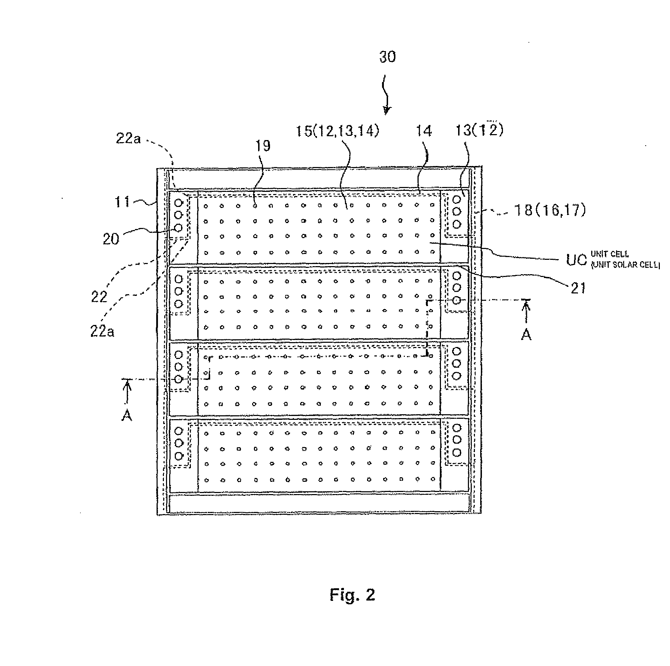

Fig. 2 is a plan view illustrating a thin-film solar cell 30 according to a second embodiment of the invention. Figs. 3A to 3D are exploded perspective views of Fig. 2. Fig. 4 is a cross-sectional view taken along the line A-A of Fig. 2. In Figs. 2 to 4, components having the same functions as those shown in Fig. 1 are denoted by the same reference numerals. A method of manufacturing the thin-film solar cell 30 according to this embodiment is basically the same as that of manufacturing the thin-film solar cell according to the related art shown in Figs. 10A to 10G, and a description thereof will be omitted. In Figs. 3A to 3D, Fig. 3A shows the overall structure of the thin-film solar cell 30, and Fig. 3B shows a laminated structure of a first electrode layer 12, a photoelectric conversion layer 13, and a second electrode layer formed on an insulating substrate 11. In addition, Fig. 3C shows the insulating substrate 11, and Fig. 3D shows a rear electrode layer 18 formed on the rear surface of the insulating substrate 11.

The thin-film solar cell 30 according to the second embodiment differs from the thin-film solar cell 10 according to the first embodiment in that the bent portion 22a of the second linearly removed portion 22 is disposed in a region in which the second electrode layer 14 is not formed, which is provided in the vicinity of a portion where the connection holes 20 are formed, in a plan view. The region in which the second electrode layer 14 is not formed includes a region of the front surface of the insulating substrate 11 in which the second electrode layer 14 is not formed and a region of the rear surface of the insulating substrate 11 corresponding to the region. In this embodiment, the bent portion 22a is formed in the region of the rear surface of the insulating substrate 11.

In the second embodiment, the first regions in which only the first electrode layer 12 and the photoelectric conversion layer 13 are formed, but the second electrode layer 14 is not formed are provided on both side of the front surface of the insulating substrate 11 in the horizontal direction of Fig. 2. In addition, the second linearly removed portion 22 has a bent structure that is bent two times at an angle of 90° on both sides of the rear surface of the insulating substrate 11 in the horizontal direction of Fig. 2 (see Fig. 3D). A region in which a series connection portion of the first electrode layer 12, which is a portion of the first region of one unit cell (UCₙ₊₁), and a bent portion of the third electrode layer 16 of an adjacent unit cell (UCₙ) overlap each other with the insulating substrate 11 interposed therebetween is an overlap region A (second region), similar to Fig. 1. This embodiments is similar to the first embodiment in that the connection holes 20 are arranged in the overlap region A.

In the second embodiment shown in Fig. 2, the bent portion is arranged in the first region. Therefore, when the thin-film solar cell according to the second embodiment has the same size as that according to the first embodiment except for the bent portion, the overlap region A shown in Fig. 2 is smaller than that shown in Fig. 1.
In this embodiment, the second linearly removed portion 22 includes the bent portion 22a. However, instead of or in addition to the second linearly removed portion 22, when the first linearly removed portion 21 includes a bent portion, the bent portion of the first linearly removed portion 21 may be disposed in the region in which the second electrode layer 14 is not formed, which is provided in the vicinity of the portion where the connection holes 20 are formed.

According to this structure, during the manufacture of the thin-film solar cell, for example, even when the photoelectric conversion layer is crystallized or damaged in the bent portion of the linearly removed portion by, for example, laser processing, a leakage path is not formed due to the electrical connection between the first electrode layer and the second electrode layer since the bent portion is disposed in the region in which the second electrode layer is not formed.

The following Table 1 shows I-V characteristics of the thin-film solar cell 10 according to the first embodiment and the thin-film solar cell 30 according to the second embodiment. The I-V characteristics are measured using a solar simulator under the condition of a solar radiation intensity of 1 SUN (1000 W/m²) after a reverse bias is applied to the manufactured thin-film solar cell. In the following Table 1, the values of the open voltage (Voc), the short-circuit current (Isc), the fill factor (FF), and the heat exchanger effectiveness (Eff) of the thin-film solar cell 30 according to the second embodiment are normalized to 1.

**[Table 1]**

| | Voc | Isc | FF | Eff |
|---|---|---|---|---|
| First embodiment | 0.98 | 1.0 | 0.98 | 0.96 |
| Second embodiment | 1.0 | 1.0 | 1.0 | 1.0 |

As can be seen from Table 1, the thin-film solar cell 10 according to the first embodiment has a low open voltage (Voc), a low fill factor (FF), and a low output, as compared to the thin-film solar cell 30 according to the second embodiment. It is considered that this is because there is a relatively large amount of leakage that cannot be removed even when a reverse bias is applied to the thin-film solar cell 10 according to the first embodiment. The two thin-film solar cells are manufactured by the same process, but are different from each other in the position where the bent portion 22a of the second linearly removed portion 22 is formed. Therefore, in the thin-film solar cell 10 according to the first embodiment, it is considered that leakage occurs in the vicinity of the bent portion 22a of the second linearly removed portion 22. Therefore, the thin-film solar cell 30 according to the second embodiment capable of reliably preventing the leakage is preferable.

Fig. 5 is a plan view illustrating a thin-film solar cell 40 according to a third embodiment of the invention. The thin-film solar cell 40 according to the third embodiment differs from the thin-film solar cell 30 according to the second embodiment in that the number of connection holes 20 increases and the connection holes 20 are arranged in a staggered arrangement, not in a straight line. Specifically, the connection holes 20 are substantially uniformly arranged in an overlap region between a portion of the first electrode layer 12 of one of two adjacent unit cells (UC) and a portion of the third electrode layer 16 of the other unit cell. According to this structure, it is possible to improve the uniformity of current flow between adjacent unit cells and reduce power collection loss.

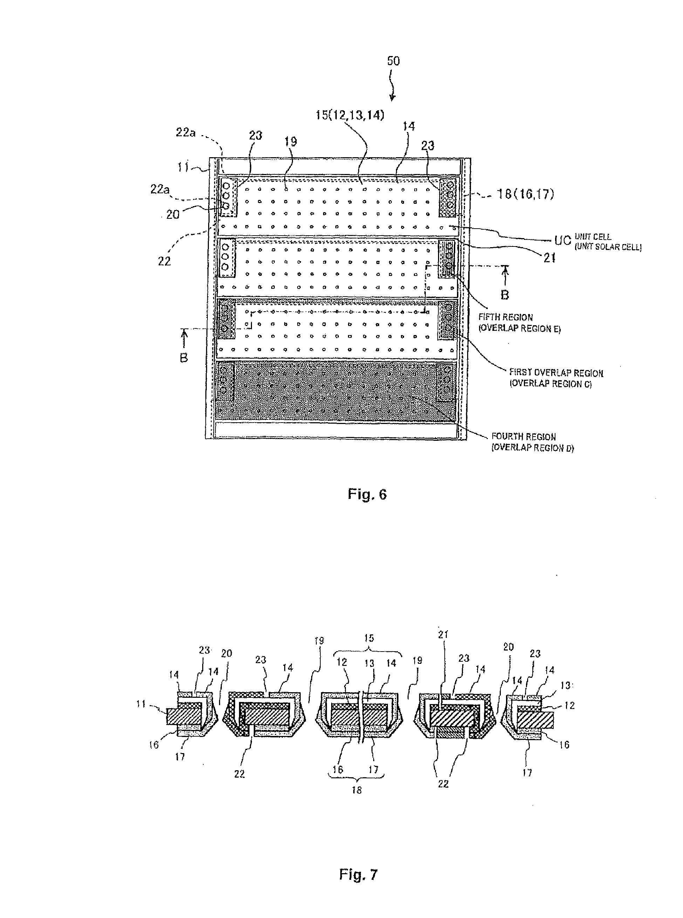

Fig. 6 is a plan view illustrating a thin-film solar cell 50 according to a fourth embodiment of the invention, and Fig. 7 is a cross-sectional view taken along the line B-B of Fig. 6. The thin-film solar cell 50 according to the fourth embodiment differs from the thin-film solar cell 30 according to the second embodiment in that the second electrode layer 14 is also formed in the vicinity of the portion in which the connection holes 20 are formed, a region in which the connection holes 20 are formed is electrically separated from a region in which the connection holes 20 are not formed in the second electrode layer 14, and the bent portion 22a of the second linearly removed portion 22 is disposed in the region in which the connection holes 20 are formed in a plan view. In the fourth embodiment, the inner region of a separation portion (second electrode layer separation portion) 23 that electrically separates the second electrode layer 14 is provided in the front surface of the insulating substrate 11. In addition, a region in which a portion of a first electrode layer formation region of one of two adjacent unit solar cells and a portion of the rear electrode layer of the other unit solar cell overlap each other with the insulating substrate interposed therebetween is a first overlap region (overlap region C). The region in which the connection holes 20 are formed is a fifth region (overlap region E), which is an overlap region in which the separation portion (second electrode layer separation portion) 23 faces the first overlap region (overlap region C) with the insulating substrate 11 interposed therebetween.

In this embodiment, the bent portion 22a is formed in the region of the rear surface of the insulating substrate 11 facing the region in which the separation portion (second electrode layer separation portion) 23. In this embodiment, the second linearly removed portion 22 includes the bent portion 22a. However, instead of or in addition to the second linearly removed portion 22, when the first linearly removed portion 21 includes a bent portion, the bent portion of the first linearly removed portion 21 may be disposed in the region in which the connection holes 20 are formed.

The thin-film solar cell 50 according to this embodiment can be manufactured as follows. In the process (Fig. 10E) of forming the second electrode layer in the method of manufacturing the thin-film solar cell according to the related art, the second electrode layer 14 is formed without using a mask, the periphery of a portion in which the connection holes 20 are formed is linearly remove by, for example, a laser patterning process to form the separation portion 23. When the second electrode layer 14 is formed, a mask for forming the separation portion 23 may be used.

According to this structure, even when the photoelectric conversion layer 13 is crystallized or damaged in the bent portion of the linearly removed portion due to, for example, laser processing during the manufacture of the thin-film solar cell, leakage does not occur in, for example, a damaged portion of the photoelectric conversion layer 13 since the second electrode layer 14 in which the bent portion is formed is electrically connected to the first electrode layer 12 through the connection holes 20 and the second electrode layer 14 is separated into a region including the connection holes 20 and a region that does not include the connection hole 20 by the separation portion 23. As a result of measurement, the thin-film solar cell 50 according to this embodiment has the I-V characteristics with a small amount of leakage, similar to the thin-film solar cell 30 according to the second embodiment.

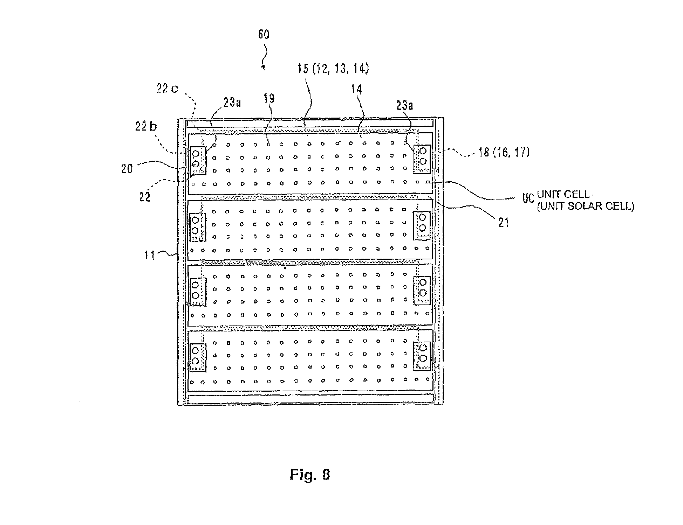

Fig. 8 is a plan view illustrating a thin-film solar cell 60 according to a fifth embodiment of the invention. The thin-film solar cell 60 according to the fifth embodiment differs from the thin-film solar cell 50 according to the fourth embodiment shown in Fig. 6 in that the area of a separation portion 23 a is small, a bent portion 22b is disposed in the separation portion 23a provided in a region in which the connection holes 20 are formed, and a bent portion 22c is disposed in a region in which the first linearly removed portion 21 is formed. According to this structure, it is also possible to prevent the occurrence of leakage.

The embodiments of the invention have been described above, but the invention is not limited to the above-described embodiments. Various modifications and changes of the invention can be made without departing from the scope and spirit of the invention.

## Claims

1. A thin-film solar cell comprising:
a plurality of unit solar cells that is formed on an insulating substrate,
wherein each of the plurality of unit solar cells includes:
a photoelectric conversion portion that includes a first electrode layer, a photoelectric conversion layer, and a second transparent electrode layer sequentially formed on a front surface of the insulating substrate; and
a rear electrode layer that is formed on a rear surface of the insulating substrate,
each of the unit solar cells includes a second region in which a portion of a first region in which the second electrode layer or the photoelectric conversion layer,
and the second electrode layer are not formed in a first electrode layer formation region of one of two adjacent unit solar cells overlaps a portion of the rear electrode layer of the other unit solar cell with the insulating substrate interposed therebetween,
the second region includes at least one connection hole passing through the insulating substrate,
the first electrode layer of one of two adjacent unit solar cells and the rear electrode layer of the other unit solar cell are electrically connected to each other through the connection holes, thereby connecting the plurality of unit solar cells in series,
each of the unit solar cells includes a third region in which the photoelectric conversion portion and the rear electrode layer that face each other with the insulating substrate interposed therebetween form a portion of the unit solar cell in a structure in which the second electrode layer and the rear electrode layer are electrically connected to each other through a plurality of collector holes passing through the insulating substrate, and
at least one of the first electrode layer and the rear electrode layer includes a bent portion and forms the second region.

2. The thin-film solar cell according to claim 1,
wherein the bent portion is disposed in the first region.

3. The thin-film solar cell according to claim 1 or 2,
wherein the plurality of collector holes is arranged so as to be dispersed in the entire third region of each of the unit solar cells.

4. A thin-film solar cell comprising:
a plurality of unit solar cells that is formed on an insulating substrate,
wherein each of the plurality of unit solar cells includes:
a photoelectric conversion portion that includes a first electrode layer, a photoelectric conversion layer, and a second transparent electrode layer sequentially formed on a front surface of the insulating substrate; and
a rear electrode layer that is formed on a rear surface of the insulating substrate,
in each of the unit solar cells, the second electrode layer and the rear electrode layer are electrically connected to each other through a plurality of collector holes passing through the insulating substrate,
each of the unit solar cells includes:
a first overlap region in which a portion of a first electrode layer formation region of one of two adjacent unit solar cells faces a portion of the rear electrode layer of the other unit solar cell with the insulating substrate interposed therebetween; and
a fourth region in which a laminated portion obtained by sequentially laminating the first electrode layer, the photoelectric conversion layer, and the second transparent electrode layer faces the rear electrode layer, with the insulating substrate interposed therebetween, to form the unit solar cell,
a portion of the fourth region is arranged so as to include a second electrode layer separation region in which at least the second electrode layer is electrically separated and the first electrode layer is not electrically separated and a fifth region in which a portion of the first electrode layer of one unit solar cell overlapped with the second electrode layer separation region faces a portion of the rear electrode layer of another unit solar cell in the first overlap region, with the insulating substrate interposed therebetween,
the collector holes are arranged in a portion of the fourth region except for the first overlap region and the second electrode layer separation region,
at least one connection hole passing through the insulating substrate is formed in the fifth region, and
the first electrode layer of one of two adjacent unit solar cells and the rear electrode layer of the other unit solar cell are electrically connected to each other through the connection holes, thereby connecting the plurality of unit solar cells in series.

5. The thin-film solar cell according to claim 4,
wherein the bent portion is disposed in the second electrode layer separation region.

6. The thin-film solar cell according to claim 4 or 5,
wherein the plurality of collector holes is arranged so as to be dispersed in the entire fourth region of each of the unit solar cells except for the first overlap region and the second electrode layer separation region.
